# EUROPÄISCHE PATENTSCHRIFT

(11) **EP 3 737 214 B1**
(45) Veröffentlichungstag und Bekanntmachung des Hinweises auf die Patenterteilung: **10.08.2022**
(21) Anmeldenummer: 20171046.4
(22) Anmeldetag: 23.04.2020
(51) Int. Cl.: H05H 7/08, H01J 27/02, H01J 27/16, H01J 27/18

(54) **CR-IONENQUELLE UND VERFAHREN ZUM BETREIBEN DIESER ECR-IONENQUELLE**
ECR ION SOURCE AND METHOD OF OPERATING THIS ECR ION SOURCE
SOURCE D'IONS ECR ET PROCÉDÉ DE FONCTIONNEMENT DE CETTE SOURCE D'IONS ECR

(30) Priorität: 08.05.2019 DE 102019111908
(43) Veröffentlichungstag der Anmeldung: 11.11.2020
(73) Patentinhaber: Dreebit GmbH, 01900 Grossröhrsdorf (DE)
(72) Erfinder: Philipp, Dr. rer. nat. Alexandra, 01847 Lohmen (DE)
(74) Vertreter: Sperling, Thomas

(56) Entgegenhaltungen:
- WO-A1-94/03919
- DE-A1-102008 027 363
- US-A- 4 792 732
- US-A- 5 146 137
- US-A1- 2007 056 515
- TAKUTO WATANABE ET AL: "Wireless telegram microwave ECRIS", AIP CONFERENCE PROCEEDINGS, Bd. 2011, 21. September 2018 (2018-09-21), Seite 090019, XP055729310, NEW YORK, US ISSN: 0094-243X, DOI: 10.1063/1.5053400
- M. LIEHR ET AL: "A low power 2.45 GHz ECR ion source for multiply charged ions", REVIEW OF SCIENTIFIC INSTRUMENTS, Bd. 63, Nr. 4, 1. April 1992 (1992-04-01), Seiten 2541-2543, XP055729131, US ISSN: 0034-6748, DOI: 10.1063/1.1142882
- KATO YUSHI ET AL: "Production of multicharged ions in a 2.45 GHz electron cyclotron resonance source directly excited in a circular TE01 mode cavity resonator", REVIEW OF SCIENTIFIC INSTRUMENTS, AIP, MELVILLE, NY, US, Bd. 75, Nr. 5, 1. Mai 2004 (2004-05-01), Seiten 1470-1472, XP012071465, ISSN: 0034-6748, DOI: 10.1063/1.1690442
- HAMADA KOUTA ET AL: "Enhancement of Beam Intensity in Electron Cyclotron Resonance Plasma by DC Biased Plate-Tuner", 2018 22ND INTERNATIONAL CONFERENCE ON ION IMPLANTATION TECHNOLOGY (IIT), IEEE, 16. September 2018 (2018-09-16), Seiten 219-222, XP033602586, DOI: 10.1109/IIT.2018.8807942 ISBN: 978-1-5386-6828-3 [gefunden am 2019-08-20]

## Beschreibung

Die Erfindung betrifft eine Multiantennen-Mikrowelleneinspeisung mit abgestimmter Phasenverschiebung für ECR-Ionenquellen und ein Verfahren zur Erzeugung von zirkular polarisierten Mikrowellen. Als Electron Cyclotron Resonance (ECR) wird die Überlagerung von elektromagnetischen Mikrowellen mit einem statischen Magnetfeld bezeichnet, wobei das statische magnetische Feld senkrecht auf dem elektrischen Wechselfeld der Mikrowelle steht und die Frequenz der eingespeisten Mikrowelle der Gyrationsfrequenz von Elektronen im Magnetfeld entspricht.

Die Anwendungsgebiete für ECR sind vielfältig. ECR-Plasmen finden Verwendung beispielsweise zum Schweißen von Bauteilen oder zum Beschichten von Folien sowie als lonenquelle bei Teilchentherapieanlagen zur Tumorbestrahlung in der Medizintechnik.

Zur Herstellung von Plasmen in ECR-Ionenquellen wird Mikrowellenstrahlung in einen zylinderförmigen Resonatorraum, die Plasmakammer, eingespeist und zur Heizung von Elektronen verwendet. Durch den Energieübertrag der Strahlung auf die Elektronen werden diese beschleunigt und stoßen mit Atomen und Ionen zusammen, woraufhin wieder neue freie Elektronen und positiv geladene Ionen mit sukzessive steigendem Ladungszustand entstehen.

Im Stand der Technik sind verschiedene Ansätze zur Nutzung der Mikrowellenstrahlung in ECR-Ionenquellen bekannt.

So ist beispielsweise die Einspeisung von linear polarisierten Mikrowellen direkt in die Plasmakammer mit einer oder mehreren Antennen bekannt, wobei als Nachteil keine Steigerung der Effizienz des Leistungsübertrags zu nennen ist.

Beispielsweise geht aus der US 5,841,237 A eine Vorrichtung und ein Verfahren für die Produktion von großen resonanten Plasmavolumen in Mikrowellen bei Electron Cyclotron Resonance-Ionenquellen hervor. Dabei werden mehrere linear polarisierte Mikrowellen in einen zylinderförmigen Resonatorraum eingespeist, wobei die Wellen mit unterschiedlicher Frequenz zur Verfügung gestellt werden. Dadurch wird es möglich, dass innerhalb einer Kavität mehrere Resonanzzonen genutzt werden können, was die Plasmaausbeute erhöht und die Plasmazusammensetzung beeinflusst.

Weiterhin geht aus der WO 2010/132069 A1 eine lonenquelle hervor, die für das ECR-Verfahren Mikrowellen über einen Hohlleiter in die Strahlenquelle einleitet.

Nach der WO 2006/100217 A1 ist eine Photonenquelle auf der Basis einer ECR-Ionenplasmaquelle offenbart, bei welcher die Mikrowellen ebenfalls über einen Hohlleiter in die Plasmavakuumkammer injiziert werden.

Aus TAKUTO WATANABE ET AL, Wireless telegram microwave ECRIS, AIP CONFERENCE PROCEEDINGS, Bd. 2011, 21. September 2018 (2018-09-21), Seite 090019, XP055729310, NEW YORK, US, ISSN: 0094-243X, DOI: 10.1063/1.5053400 geht eine Electron Cyclotron Resonance-Ionenquelle hervor, welche zwei einzelne Ionenquellen mit jeweils zugeordneten Mikrowellenquellen aufweist.

Aus der US 4 792 732 A geht ein Radio Frequenz Plasma Generator hervor. Offenbart ist ein Plasmagenerator zur Anregung von Elektronen im Plasma auf ein einheitliches Energieniveau. In einer bevorzugten Ausführungsform umgeben zwei Sätze von zueinander senkrechten Elektroden einen Gasbehälter, wobei ein Satz durch einen neunzig Grad Phasenschieber angetrieben wird, um ein zirkular polarisiertes Feld in der Plasmakammer zu erzeugen. Alternative Mittel sind für die Einführung von zirkular polarisierten HF-Wellen in die Plasmakammer offenbart.

Die US 5 146 137 A bezieht sich auf eine Vorrichtung zur Erzeugung eines Plasmas mittels zirkular polarisierter Hochfrequenzwellen.

Neben der Verwendung von linear polarisierten Mikrowellen ist bekannt, dass zirkular polarisierte Mikrowellen einen positiven Effekt auf die Effizienz des ECR-Verfahren besitzen.

So ist die Einspeisung von zirkular polarisierten Wellen in die Plasmakammer bekannt, wobei die Zirkularpolarisation der Mikrowellen außerhalb der Plasmakammer vorgenommen wird und zum Transport der Wellen die Verwendung von Hohlleitern erforderlich ist. Da mit Fortschreiten der technischen Entwicklung vermehrt Halbleitergeneratoren mit Koaxialausgängen zur Erzeugung von Mikrowellen eingesetzt werden, sind Anwendungen mit Hohlleitern unter Umständen apparativ aufwendiger und somit nachteilig.

Aus der EP 0 434 933 A2 ist beispielsweise eine derartige Einrichtung für die Erzeugung eines Plasmas durch Mikrowellen bekannt, bei welcher die Erzeugung eines Plasmas mithilfe zirkular polarisierter Mikrowellen erfolgt. Dabei wird die aus einem Mikrowellengenerator kommende, linear polarisierte Mikrowelle in einem Modenwandler und einem Standard-Rundhohlleiter in eine zirkular polarisierte Welle umgewandelt und dann über ein Horn auf den Querschnitt einer Plasmakammer gegeben. Somit erfolgt die Erzeugung der zirkular polarisierten Mikrowellen außerhalb des Resonatorraumes und die zirkular polarisierten Mikrowellen müssen apparativ aufwändig über Hohlleiter transportiert und in den Resonatorraum eingespeist werden.

Aus der WO/9403919 ist eine Ionenquellenvorrichtung bekannt,wobei die Mikrowellenleistung direkt mit N Rechteckhohlleitern mit einem Winkelabstand von 2n/N um die Plasmakammerachse herum durch vakuumdichte, mikrowellentransparente Fenster zwischen den Polen von Multipolmagneten hindurch radial, mit elektrischem Feldvektor senkrecht zur Ionenquellenachse in die Plasmakammer eingekoppelt wird, und wobei die Leistung und die Phasenlage der N Teilwellen so gewählt werden, dass sich bei N = 2 in der Plasmakammer eine stehende, linear polarisierte Mikrowelle mit Feldmaximum auf der Ionenquellenachse ausbildet und bei N > 2 eine stehende, zirkular polarisierte Mikrowelle mit Feldmaximum auf der Ionenquellenachse ausbildet.

Den ECR-Ionenquellen nach dem Stand der Technik ist gemeinsam, dass die Einspeisung von Mikrowellen genutzt wird, um Elektronen zu heizen und das Plasma zu erzeugen und zu verbessern.

Die dabei verfolgten Lösungsansätze bestehen zum einen darin, linear polarisierte Mikrowellen in den Plasmaraum zu injizieren oder bereits zirkular polarisierte Mikrowellen von außen über einen Hohlleiter in den Plasmaraum einzubringen, wobei ein weiteres Bauteil zwischen Generator und Kammer eingefügt wird, in dem die Zirkularpolarisation erzeugt wird.

Die bestehenden Probleme sind darin zu sehen, dass die Steigerung der Effizienz des Leistungsübertrags von Mikrowellenstrahlung auf Elektronen in ECR-Ionenquellen bei fest vorgeschriebener Mikrowellenfrequenz, Mikrowellenleistung und Hohlraumresonatorgeometrie verbessert werden muss. Weiterhin besteht der Nachteil, dass die erhältlichen Mikrowellenerzeuger nicht direkt zirkular polarisierte Mikrowellen liefern.

Die Aufgabe der Erfindung wird darin gesehen in der ECR-Ionenquelle zirkular polarisierte Mikrowellen mit geringem apparativen und energetischen Aufwand zu erzeugen und zur Heizung der Elektronen zur Verfügung zu stellen.

Die Aufgabe wird durch eine ECR-Ionenquelle und ein Verfahren zum Betreiben der ECR-Ionenquelle mit den Merkmalen der selbstständigen Patentansprüche gelöst. Weiterbildungen sind in den abhängigen Patentansprüchen angegeben.

Die Aufgabe der Erfindung wird durch eine ECR-Ionenquelle mit einer kreiszylinderförmigen Plasmakammer und Magneten zur Erzeugung eines Magnetfeldes zum Einschluss des Plasmas in der Plasmakammer gelöst. Weiterhin ist ein Mikrowellengenerator außerhalb der Plasmakammer zur Erzeugung von mindestens zwei Mikrowellensignalen vorgesehen, wobei jeweils eine Antenne pro Signal zur Einspeisung von linear polarisierten Mikrowellen radial in die Plasmakammer hineinragt. Dabei sind die Antennen zur phasenverschobenen Einspeisung der Mikrowellen zur Bildung einer zirkular polarisierten Mikrowelle mit einem Winkelversatz alpha zueinander in der Plasmakammer angeordnet. Die Phasenverschiebung der an den Antennen anliegenden Mikrowellensignale wird auf deren Winkelversatz in der Anordnung angepasst.

Erfindungsgemäß sind genau zwei der mehreren Antennen auf einer Kreislinie eines Kreiszylinderquerschnittes der Plasmakammer mit einem Winkelversatz alpha angeordnet. Die Antennen sind somit in einer Querschnittsebene der kreiszylinderförmigen Plasmakammer angeordnet und ragen radial nach innen. Erfindungsgemäß beträgt der Winkelversatz alpha 90 Grad und bedingt eine Phasenverschiebung der angelegten Mikrowellensignale von 90 Grad.

Besonders vorteilhaft ist die ECR-Ionenquelle dahingehend ausgestaltet, dass Koaxialkabel zum Transport der linear polarisierten Mikrowellen vom Mikrowellenerzeuger zu den Antennen in der Plasmakammer angeordnet sind. Die Antennen für die Mikrowelleneinspeisung in der Plasmakammer sind vorteilhaft als Stabantennen ausgebildet, so dass eine apparativ sehr einfache, standardisierte, preiswerte und robuste Realisierung der Einspeisung der Mikrowellen in die Plasmakammer über die Stabantennen erfolgen kann.

Die Aufgabe der Erfindung wird auch durch ein Verfahren zum Betreiben einer ECR-Ionenquelle gemäß Anspruch 5 gelöst, wobei in einem ersten Schritt zwei phasenverschobene Mikrowellensignale über Koaxialkabel zu zwei in einem Winkelversatz alpha von 90° angeordneten Antennen geführt werden und in einem zweiten Schritt zwei linear polarisierte Mikrowellen über die Antennen in die Plasmakammer phasenverschoben eingestrahlt werden, wodurch im dritten Schritt die linear polarisierten Mikrowellen zu einer zirkular polarisierten Mikrowelle überlagert werden.

Erfindungsgemäß weisen die linear polarisierten Mikrowellen eine Phasenverschiebung von 90° auf.

Nach einer vorteilhaften Ausgestaltung werden mehrere linear polarisierte Mikrowellen paarweise mit einer Phasenverschiebung alpha von in die Plasmakammer eingeführt.

Nach einer weiteren Ausgestaltung, die nicht durch die beanspruchte Erfindung abgedeckt ist, werden drei Antennen mit je 120° Versatz in der Plasmakammer angeordnet, die dann Mikrowellen mit 120° Phasenverschiebung einspeisen.

In Ausführungsformen, die nicht durch die beanspruchte Erfindung abgedeckt sind, werden eine beliebige Anzahl n Antennen mit je (360/n)° in der Plasmakammer angeordnet und die Phasenverschiebung der anliegenden Signale entsprechend auf (360/n)° angepasst.

Die Konzeption der Erfindung besteht darin, dass zirkular polarisierte Mikrowellenstrahlung in den zylinderförmigen Resonatorraum eingespeist und zur Heizung der Elektronen verwendet wird. Die zu heizenden Elektronen bewegen sich spiralförmig um die Feldlinien des zugehörigen Magnetfeldes in der ECR-Plasmakammer. Um diese effizient zu heizen, sollte die Polarisierungsrichtung des elektrischen Felds der Mikrowelle zur Bewegungsrichtung der Elektronen passen. Daher kann die Effizienz des Energieübertrags erhöht werden, wenn nicht nur eine lineare Polarisationsrichtung der Mikrowellenstrahlung verwendet wird, welche die Spiralbahn der Elektronen nur an wenigen Punkten optimal bedient. Die Umsetzung der Konzeption besteht nunmehr darin, dass man mehrere linear polarisierte Wellen einspeist, die sich mit der richtigen Phasenverschiebung überlagern. Dadurch entsteht eine zirkular polarisierte Welle, die besser mit der spiralförmigen Bewegung der Elektronen vereinbart ist. Somit besteht der Kern der Erfindung in der Überlagerung mehrerer linear polarisierter Wellen, eingespeist durch mehrere Antennen, die in radialer Richtung in die zylinderförmige Plasmakammer hineinragen. Die jeweilige Phasenverschiebung wird auf die geometrischen Positionen der Antennen angepasst und entspricht dem Winkelversatz der Antennen entlang des Kreisquerschnitts des Zylinders. Dadurch entsteht eine zirkular polarisierte Welle direkt in der zylindrischen Kammer. Ein besonderer Vorteil besteht somit darin, dass die zirkular polarisierte Welle unmittelbar in der Plasmakammer erzeugt wird, wobei für die Einspeisung der Mikrowelle keine Hohlleiter erforderlich sind, sondern flexibel verlegbare Koaxialkabel für den Transport der Mikrowellen hin zur ECR-Ionenquelle verwendet werden können. Die Verwendung von Koaxialkabeln für den Mikrowellentransport ist besonders vorteilhaft, da die technologische Entwicklung hin zu Halbleitergeneratoren zur Mikrowellenerzeugung verläuft, die typischerweise Koaxial-Ausgänge verwenden.

Weitere Einzelheiten, Merkmale und Vorteile von Ausgestaltungen der Erfindung ergeben sich aus der nachfolgenden Beschreibung von Ausführungsbeispielen mit Bezugnahme auf die zugehörigen Zeichnungen. Es zeigen:
Fig. 1: Längsschnitt durch eine ECR-Ionenquelle und
Fig. 2: Querschnitt der Plasmakammer einer ECR-Ionenquelle

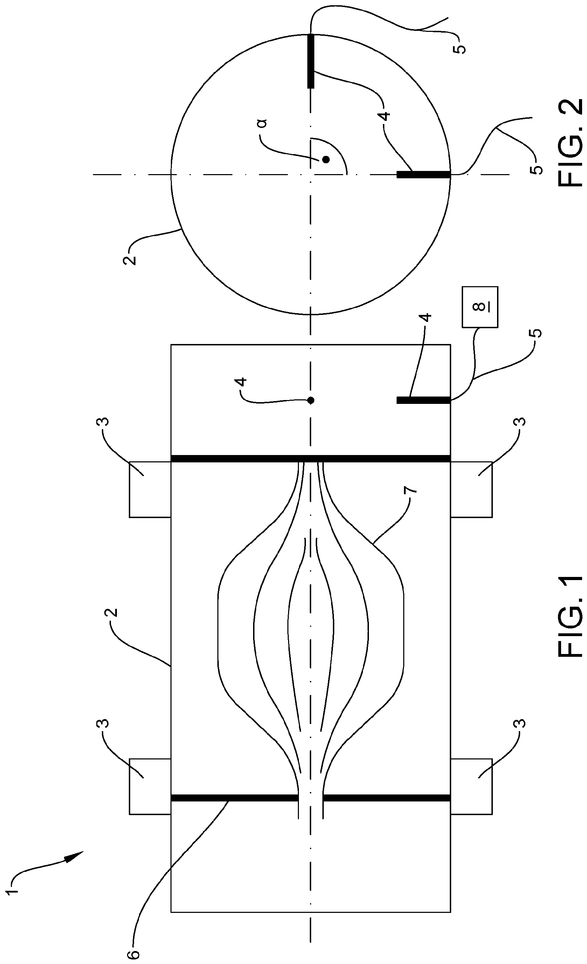

In Figur 1 ist schematisiert ein Längsschnitt einer ECR-Ionenquelle 1 dargestellt. Die ECR-Ionenquelle 1 besteht im Wesentlichen aus einer unter Vakuum stehenden Plasmakammer 2, in welcher das Plasma entsteht. Weiterhin sind beidseits der kreiszylindrischen Plasmakammer 2 Magnete 3 in Form von Ringmagneten um die Plasmakammer 2 herum in einem Abstand angeordnet, in dem sich dann die Magnetfeldlinien 7, in angedeuteter Darstellung, verteilen und das Plasma in dem eingeschlossenen Bereich entsteht. Der Kreiszylinder der Plasmakammer 2 ist auf einer Seite geschlossen und auf der anderen Seite befindet sich die Blende 6, durch welche der Teilchenstrahl gerichtet die Plasmakammer 2 verlassen kann. In die Plasmakammer 2 werden linear polarisierte Mikrowellen über Antennen 4 eingespeist, wobei die Mikrowellen außerhalb der ECR-Ionenquelle 1 in einem Mikrowellenerzeuger 8 erzeugt und über Koaxialkabel 5 den Antennen 4 zugeführt werden. Die Antennen 4 ragen in radialer Richtung in den Kreiszylinder der Plasmakammer 2 hinein. Im dargestellten Ausführungsbeispiel sind genau zwei Antennen 4 vorgesehen. Die

Anordnung der Antennen 4 ist von entscheidender Bedeutung für die anzulegende Phasenverschiebung der Mikrowellensignale, deren Überlagerung besonders effiziente zirkular polarisierte Mikrowellen ergibt, welche zur Heizung der Elektronen eingesetzt werden, die sich spiralförmig um die Magnetfeldlinien 7 herum im Raum zwischen den Magneten 3 bewegen.

In Figur 2 ist eine Plasmakammer 2 schematisch in der Seitenansicht in der Ebene der Antennen 4 dargestellt, wobei der kreiszylindrische Querschnitt sichtbar wird. Gemäß der dargestellten Ausgestaltung der Erfindung ragen genau zwei Antennen 4 in radialer Richtung und mit einem Winkelversatz alpha auf dem Kreis von 90 Grad in das Innere der Plasmakammer 3 hinein. Die Antennen 4 sind vorzugsweise als Stabantenne ausgebildet.

Die Antennen 4 sind über Koaxialkabel 5 mit dem nicht dargestellten Mikrowellenerzeuger verbunden.

### Bezugszeichenliste

- 1: ECR-Ionenquelle
- 2: Plasmakammer
- 3: Magnet
- 4: Antenne
- 5: Koaxialkabel
- 6: Blende
- 7: Magnetfeldlinie
- 8: Mikrowellenerzeuger

- α: Winkelversatz alpha

## Patentansprüche

1. ECR-Ionenquelle (1) mit einer kreiszylinderförmigen Plasmakammer (2) und Magneten (3) zur Erzeugung eines Magnetfeldes zum Einschluss des Plasmas in der Plasmakammer (2) sowie einem Mikrowellenerzeuger (8) zur Erzeugung von mindestens zwei Mikrowellensignalen außerhalb der Plasmakammer (2), **dadurch gekennzeichnet, dass** mehrere Antennen (4) mit einem bestimmten Winkelversatz (alpha)
radial in die Plasmakammer (2) hineinragend zur Abstrahlung von linear polarisierten Mikrowellen angeordnet sind,
wobei der Winkelversatz (alpha) mit 90° ausgebildet ist,
wobei genau zwei Antennen der mehreren Antennen (4) auf einer Kreislinie eines Kreiszylinderquerschnitts der Plasmakammer angeordnet sind,
und wobei die ECR-Ionenquelle derart eingerichtet ist, dass an den Antennen (4) phasenverschobene Mikrowellensignale zur Bildung einer zirkular polarisierten Mikrowelle innerhalb der Plasmakammer (2) angelegt werden, und dass eine
Phasenverschiebung der linear polarisierten Mikrowellen von 90° realisiert wird.

2. ECR-Ionenquelle (1) nach Anspruch 1, **dadurch gekennzeichnet, dass** mehrere Paare von Antennen (4) in verschiedenen Querschnittsebenen der kreiszylinderförmigen Plasmakammer (2) angeordnet sind.

3. ECR-Ionenquelle (1) nach Anspruch 1 oder 2, **dadurch gekennzeichnet, dass** Koaxialkabel (5) zum Transport der Mikrowellensignale vom Mikrowellenerzeuger (8) zu den Antennen (4) in der Plasmakammer (2) angeordnet sind.

4. ECR-Ionenquelle (1) nach einem der Ansprüche 1 bis 3, **dadurch gekennzeichnet, dass** die Antennen (4) für die Mikrowelleneinspeisung in die Plasmakammer (2) als Stabantennen ausgebildet sind.

5. Verfahren zum Betreiben einer ECR-Ionenquelle (1) nach einem der vorangegangenen Ansprüche, **dadurch gekennzeichnet, dass**
zwei phasenverschobene Mikrowellensignale über ein Koaxialkabel (5) zu zwei mit dem
Winkelversatz (alpha) von 90° in der Plasmakammer angeordneten Antennen (4) geführt werden
und
- die Antennen (4) zwei linear polarisierte Mikrowellen in die Plasmakammer (2) phasenverschoben einstrahlen, wodurch
- die linear polarisierten Mikrowellen zu einer zirkular polarisierten Mikrowelle überlagert werden und
- die linear polarisierten Mikrowellen eine Phasenverschiebung von 90° aufweisen.

6. Verfahren nach Anspruch 5, **dadurch gekennzeichnet, dass** mehrere linear polarisierte Mikrowellen paarweise mit einer Phasenverschiebung (alpha)
von 90° in die Plasmakammer (2) eingeführt werden.

## Claims

1. An ECR ion source (1) having a circular cylindrical plasma chamber (2) and magnets (3) for generating a magnetic field in order to enclose the plasma in the plasma chamber (2), and having a microwave generator (8) for generating at least two microwave signals outside the plasma chamber (2), **characterised in that** multiple antennas (4) are arranged protruding radially into the plasma chamber (2) at a certain angular offset (alpha) in order to emit linearly polarised microwaves, wherein the angular offset (alpha) is designed to be 90°,
wherein exactly two antennas of the multiple antennas (4) are arranged on a circumference of a circular cylinder cross-section of the plasma chamber,
and wherein
the ECR ion source is arranged such that
phase-shifted microwave signals are applied to the antennas (4) in order to form a circularly polarised microwave inside the plasma chamber (2),
and that a phase shift of the linearly polarised microwaves of 90° is realised.

2. The ECR ion source (1) according to claim 1, **characterised in that** multiple pairs of antennas (4) are arranged in different cross-sectional planes of the circular cylindrical plasma chamber (2).

3. The ECR ion source (1) according to claim 1 or 2, **characterised in that** coaxial cables (5) are arranged to transport the microwave signals from the microwave generator (8) to the antennas (4) in the plasma chamber (2).

4. The ECR ion source (1) according to one of claims 1 to 3, **characterised in that** the antennas (4) for feeding microwaves into the plasma chamber (2) are designed as rod antennas.

5. A method for operating an ECR ion source (1) according to one of the preceding claims, **characterised in that**
- two phase-shifted microwave signals are guided via a coaxial cable (5) to two antennas (4) which are arranged in the plasma chamber at the angular offset (alpha) of 90°, and
- the antennas (4) emit two linearly polarised microwaves into the plasma chamber (2) in a phase-shifted manner, whereby
- the linearly polarised microwaves are superposed to form a circularly polarised microwave, and
- the linearly polarised microwaves have a phase shift of 90°.

6. The method according to claim 5, **characterised in that** multiple linearly polarised microwaves are introduced into the plasma chamber (2) in pairs with a phase shift (alpha) of 90°.

## Revendications

1. Source d'ions ECR (1) avec une chambre à plasma (2) de forme circulaire cylindrique et des aimants (3) pour la génération d'un champ magnétique pour le confinement du plasma dans la chambre à plasma (2) et avec un générateur d'hyperfréquences (8) pour la génération d'au moins deux signaux à hyperfréquences en dehors de la chambre à plasma (2), **caractérisée en ce qu'**une pluralité d'antennes (4) pénétrant radialement dans la chambre à plasma (2) sont disposées avec un certain décalage angulaire (alpha) par rapport au rayonnement d'hyperfréquences à polarisation linéaire, le décalage angulaire (alpha) étant formé à 90°, précisément deux antennes de la pluralité d'antennes (4) étant disposées sur une ligne circulaire d'une section circulaire cylindrique de la chambre à plasma, et la source d'ions ECR étant arrangée de sorte que des signaux à hyperfréquences déphasées sont appliqués au niveau des antennes (4) pour former une hyperfréquence à polarisation circulaire à l'intérieur de la chambre à plasma (2), et **en ce qu'**un déphasage à 90° des hyperfréquences à polarisation linéaire est réalisé.

2. Source d'ions ECR (1) selon la revendication 1, **caractérisée en ce que** plusieurs paires d'antennes (4) sont disposées dans différents niveaux de section de la chambre à plasma (2) circulaire cylindrique.

3. Source d'ions ECR (1) selon la revendication 1 ou 2, **caractérisée en ce que** des câbles coaxiaux (5) pour le transport des signaux à hyperfréquences du générateur d'hyperfréquences (8) aux antennes (4) sont disposés dans la chambre à plasma (2).

4. Source d'ions ECR (1) selon l'une quelconque des revendications 1 à 3, **caractérisée en ce que** les antennes (4) sont formées comme des antennes bâtons pour l'alimentation des hyperfréquences dans la chambre à plasma (2).

5. Procédé d'exploitation d'une source d'ions ECR (1) selon l'une quelconque des revendications précédentes, **caractérisé en ce que**
- deux signaux à hyperfréquences déphasées sont guidés par des câbles coaxiaux (5) vers deux antennes (4) disposées dans la chambre à plasma avec le décalage angulaire (alpha) de 90°, et
- les antennes (4) irradient par déphasage deux hyperfréquences à polarisation linéaire vers la chambre à plasma (2),
- les hyperfréquences à polarisation linéaire étant superposées à une hyperfréquence à polarisation circulaire, et
- les hyperfréquences à polarisation linéaire présentent un déphasage de 90°.

6. Procédé selon la revendication 5, **caractérisé en ce que** plusieurs hyperfréquences à polarisation linéaire sont guidées par paires vers la chambre à plasma (2) à un déphasage (alpha) de 90°.
